# DEMANDE DE BREVET EUROPEEN

(11) **EP 3 157 063 A1**
(43) Date de publication de la demande: **19.04.2017**
(21) Numéro de dépôt: 16190766.2
(22) Date de dépôt: 27.09.2016
(51) Int. Cl.: H01L 31/0224, H02S 20/23, H01L 31/0468

(54) **CELLULE PHOTOVOLTAÏQUE POUR SERRE AGRICOLE**

(30) Priorité: 16.10.2015 FR 1559885
(71) Demandeur: COMMISSARIAT À L'ÉNERGIE ATOMIQUE ET AUX ÉNERGIES ALTERNATIVES, 75015 Paris (FR)
(72) Inventeur: DUCROS, Cédric, 38690 Bevenais (FR); EMIEUX, Fabrice, 38340 Voreppe (FR); PEREIRA, Alexandre, 38950 Saint-Martin-Le-Vinoux (FR)
(74) Mandataire: Cabinet Camus Lebkiri

(57) **Abrégé**

L'invention concerne une cellule photovoltaïque pour serre agricole, la cellule photovoltaïque comportant :
- un substrat (1) transparent ;
- une première et une deuxième électrode (2, 3) en oxyde transparent conducteur;
- une couche absorbante (4) en silicium amorphe, la couche absorbante (3) étant disposée entre la première et la deuxième électrode (2, 3);

Caractérisée en ce que au moins une des électrodes (2, 3) est une grille (6) percée par des ouvertures (7), chaque ouverture (7) présentant des dimensions transversales (d) comprises entre 0.5 µm et 10 µm, et de préférence entre 1 µm et 2.5 µm, la grille (6) présentant une épaisseur (em) comprise entre 250 nm et 2,5 µm.

## Description

### DOMAINE TECHNIQUE

La présente invention concerne une cellule photovoltaïque pour serre agricole, ainsi qu'une serre agricole pourvue d'une telle cellule photovoltaïque.

### ETAT DE LA TECHNIQUE ANTERIEUR

Comme décrit dans le document FR2956775, il est connu de disposer des modules photovoltaïques sur des toits de serre agricole afin d'améliorer la culture d'espèces végétales dans ces serres. Toutefois, ces modules photovoltaïques entrent en compétition avec les espèces végétales contenues dans les serres pour l'utilisation de la lumière solaire.

### EXPOSE DE L'INVENTION

L'invention vise à remédier aux inconvénients de l'état de la technique en proposant une cellule solaire qui n'entre pas en compétition avec les plantes contenues dans une serre mais qui dans le même temps présente un rendement suffisant pour une utilisation agricole.

Pour ce faire, un premier aspect de l'invention concerne une cellule photovoltaïque pour serre agricole, la cellule photovoltaïque comportant :
- un substrat transparent ;
- une première et une deuxième électrode en oxyde transparent conducteur, au moins une des électrodes présentant une forme de grille percée par des ouvertures, chaque ouverture présentant des dimensions transversales comprises entre 0.5 µm et 10 µm, et de préférence entre 1 µm et 2.5 µm.
- une couche absorbante en silicium amorphe, la couche absorbante étant disposée entre la première et la deuxième électrode;

Le fait de réaliser les électrodes en oxyde transparent conducteur permet à la cellule solaire de laisser passer une grande partie du spectre lumineux de longueurs d'onde comprises entre 400 et 520 nm, ce qui est avantageux puisque ces longueurs d'onde sont utilisées par les plantes pour la photosynthèse. En outre, le fait de réaliser au moins une électrode, et de préférence les deux électrodes, sous forme de grille avec des ouvertures comprises entre 0.5 µm et 10 µm, et de préférence entre 1 µm et 2.5 µm, permet d'augmenter leur transparence aux longueurs d'onde comprises entre 400 et 520 nm et entre 620 et 700 nm. La cellule solaire ainsi formée présente une absorption maximale entre 520 et 620 nm et minimale aux longueurs d'onde utilisées par les plantes pour la photosynthèse.

En outre, le fait d'avoir des électrodes sous forme de grille avec des ouvertures de dimensions comprises entre 0.5 µm et 10 µm, et de préférence entre 1 µm et 2.5 µm, permet à la grille d'être suffisamment efficace pour collecter la majeure partie des porteurs générés par la couche absorbante.

Un autre avantage des électrodes sous forme de grille avec des ouvertures de dimensions comprises entre 0.5 µm et 10 µm est qu'elles induisent du piégeage optique au sein de la couche absorbante grâce à la texturation induite de l'interface entre la grille et la couche absorbante. Ce piégeage optique permet d'augmenter le rendement quantique de la cellule dans la gamme de longueur d'onde 520-620 nm, et donc d'améliorer le rendement de la cellule. Ce phénomène est particulièrement marqué lorsque la grille présente des ouvertures de dimensions comprises entre 1 µm et 2.5 µm.

La cellule photovoltaïque peut également présenter une ou plusieurs des caractéristiques ci-après prises individuellement ou selon toutes les combinaisons techniquement possibles.

Avantageusement, le substrat est souple de façon à pouvoir déposer la cellule photovoltaïque sur des supports de formes variées.

Avantageusement, les deux électrodes sont des grilles, chaque grille étant percée par des ouvertures, chaque ouverture présentant des dimensions transversales comprises entre 0.5 µm et 10 µm, et de préférence entre 1 µm et 2.5 µm. Le fait de réaliser les deux électrodes sous forme de grille permet de renforcer la transparence de la cellule solaire aux longueurs d'onde utiles pour les plantes, tout en évacuant de manière efficace les porteurs de charge produits par la couche absorbante. Avantageusement, chaque grille présente une épaisseur comprise entre 250 nm et 2,5 µm, ce qui lui permet d'avoir une bonne conductivité électrique de façon à ce qu'elle évacue de manière efficace les porteurs générés par la couche absorbante.

Avantageusement, chaque grille comporte des parois, chaque paroi séparant deux ouvertures consécutives, chaque paroi présentant une largeur supérieure à 100 nm, ce qui permet de conserver la continuité électrique de l'électrode ainsi formée.

Avantageusement, chaque grille est réalisée dans un des oxydes transparents conduteurs suivants : oxyde de zinc dopé, oxyde d'indium dopé, oxyde d'indium dopé à l'oxyde d'étain et à l'oxyde de zinc.

Avantageusement, la couche absorbante présente une épaisseur comprise entre 40 et 100 nm, et de préférence entre 50 et 70 nm, ce qui permet à la cellule photovoltaïque d'être transparente aux longueurs d'onde utiles à la photosynthèse, c'est-à-dire aux longueurs d'onde comprises entre 400 et 520 nm et entre 620 et 700 nm, tout en ayant un rendement suffisant pour que les cellules photovoltaïque soient utilisées dans des serres agricoles.

Avantageusement, afin d'augmenter la transparence de la cellule aux longueurs d'onde comprises entre 400 et 520 nm et entre 620 et 700 nm, la cellule photovoltaïque présente les indices optiques suivants :
- le substrat présente un indice optique compris entre 1.4 et 1.6;
- chaque électrode présente un indice optique compris entre 1.5 et 2.5 ;
- la couche absorbante présente un indice optique compris entre 3 et 4.

Pour cela :
- le substrat peut être réalisé entre verre ou en polymère, comme par exemple en PET ou polycarbonate ;
- la couche absorbante est réalisée en silicium amorphe ;
- chaque électrode est réalisée en oxyde transparent conducteur.

Avantageusement, la couche absorbante est réalisée dans un matériau semiconducteur présentant un gap compris entre 1.5 et 1.9 eV, ce qui permet à la couche absorbante d'être transparente aux longueurs d'onde supérieure à 600 nm, qui sont utiles à la croissance des plantes.

Pour cela, la couche absorbante peut comporter du silicium amorphe hydrogéné.

Selon un mode de réalisation, la couche absorbante comporte en outre du carbone, ce qui permet de décaler l'absorption de la couche absorbante vers les longueurs d'onde inférieures à 650nm.

Selon un mode de réalisation, la couche absorbante comporte en outre du germanium, ce qui permet de décaler l'absorption de la couche absorbante vers les longueurs d'onde supérieures à 650nm.

Un deuxième aspect de l'invention concerne une serre agricole comportant une paroi transparente, la paroi transparente étant recouverte au moins en partie d'une cellule photovoltaïque selon le premier aspect de l'invention.

### BREVES DESCRIPTION DES FIGURES

D'autres caractéristiques et avantages de l'invention ressortiront à la lecture de la description détaillée qui suit, en référence aux figures annexées, qui illustrent :
- La figure 1, une vue en coupe schématique d'une cellule photovoltaïque selon un mode de réalisation de l'invention ;
- La figure 2, une représentation schématique en vue de dessus d'une électrode de la cellule de la figure 1 ;
- La figure 3, une image au microscope électronique à balayage d'une électrode de la cellule de la figure 1 ;
- La figure 4, un spectre d'absorption des pigments bruts utiles à la photosynthèse et l'activité photosynthétique liée à cette absorption ;
- La figure 5, différentes courbes représentant l'absorption de différents types d'électrodes en fonction de la longueur d'onde ;
- La figure 6, une courbe représentant la densité de courant en fonction de la tension dans une cellule solaire selon un mode de réalisation de l'invention, présentant une tension V_{oc}=895mV, J_{sc}=5.2 mA/cm², FF=66.7% et un rendement de 3,11% ;
- La figure 7, des courbes représentant la transmission optique et le rendement quantique de cellule photovoltaïque en fonction de la longueur d'onde, ainsi que la gamme d'absorption de la photosynthèse ;
- La figure 8, des courbes de croissance sous serre de micro-algues en l'absence de cellule photovoltaïque et en présence de cellules photovoltaïque selon un mode de réalisation de l'invention ;
- La figure 9, des étapes d'un procédé de réalisation d'une cellule photovoltaïque selon un mode de réalisation de l'invention.

Pour plus de clarté, les éléments identiques ou similaires sont repérés par des signes de références identiques sur l'ensemble des figures.

### DESCRIPTION DETAILLEE D'AU MOINS UN MODE DE REALISATION

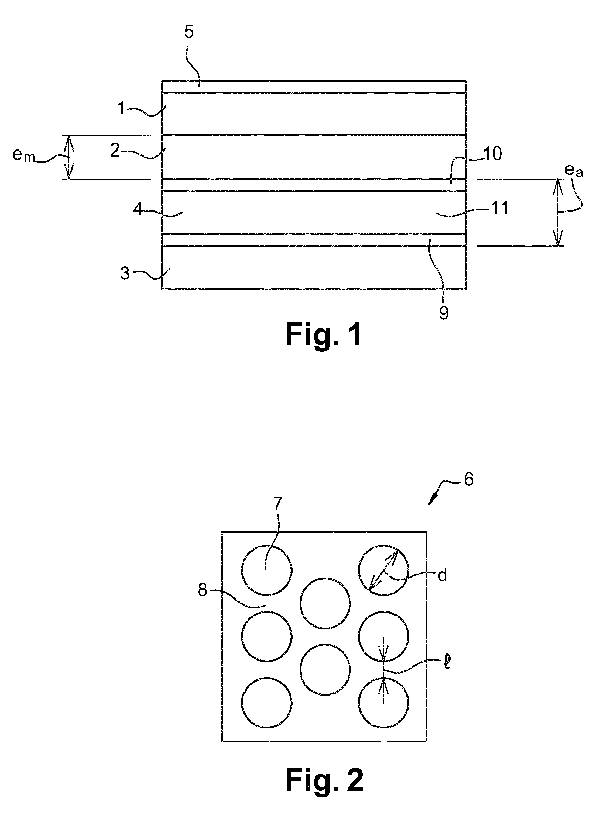

La figure 1 représente une cellule photovoltaïque selon un mode de réalisation de l'invention. Cette cellule photovoltaïque comporte un substrat 1, une première électrode 2 déposée sur le substrat, une couche absorbante 4 déposée sur la première électrode et une deuxième électrode 3 déposée sur la couche absorbante 4.

### Substrat :

Le substrat 1 est transparent. Le substrat 1 présente de préférence un indice optique compris entre 1.4 et 1.6. Le substrat 1 est de préférence souple afin de pouvoir être déposé sur des supports de formes variées. Le substrat 1 peut par exemple être réalisé en verre ou en polymère. Le polymère utilisé peut par exemple être du polytéréphtalate d'éthylène (PET) ou du polycarbonate.

Le substrat 1 peut également être recouvert d'une couche antireflet 5 afin d'améliorer la transparence de la cellule photovoltaïque.

### Electrode :

La première et la deuxième électrode 2, 3 sont réalisées dans un oxyde transparent conducteur afin de laisser passer la majorité des longueurs d'onde utiles à la photosynthèse des plantes.

Pour cela, les électrodes 2, 3 sont de préférence réalisées dans un des oxydes conducteurs transparents suivants : oxyde de zinc dopé, oxyde d'indium dopé, oxyde d'indium dopé à l'oxyde d'étain et à l'oxyde de zinc.

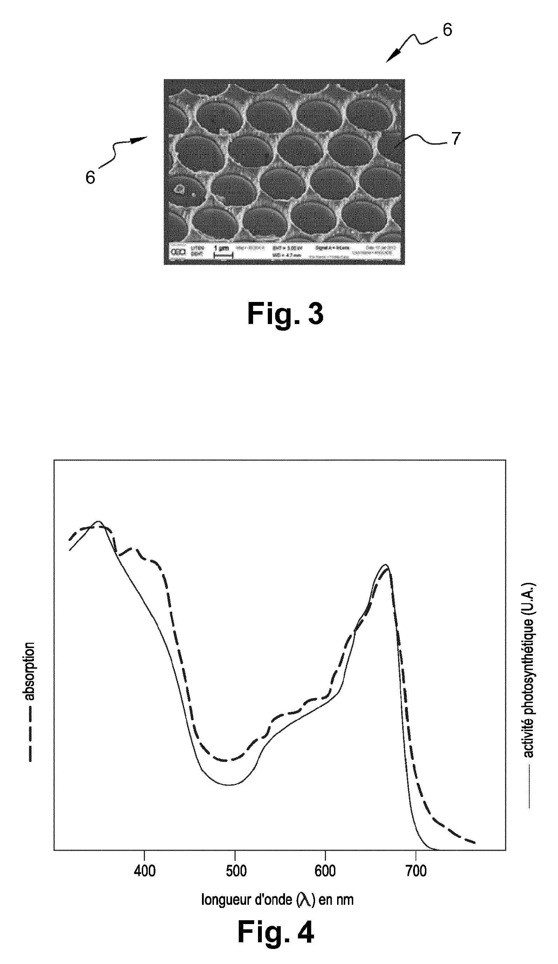

La première et la deuxième électrode 2, 3 présentent de préférence un indice optique compris entre 1.5 et 2.5. En outre, afin d'optimiser la transparence des électrodes 2, 3 pour les longueurs d'onde inférieures à 520 nm, les deux électrodes présentent de préférence une forme de grille 6 comme représenté sur les figures 2 et 3.

Chaque grille 6 comporte une pluralité d'ouvertures 7 séparées les unes des autres par des parois 8. Les ouvertures 7 présentent de préférence une forme circulaire car elles sont ainsi plus faciles à réaliser. Chaque ouverture 7 présente des dimensions transversales d comprises entre 0.5 µm et 10 µm, et de préférence entre 1 µm et 2.5 µm. De telles dimensions transversales d permettent à la grille 6 d'être transparente aux longueurs d'onde inférieures à 520 nm, ce qui est particulièrement avantageux car ces longueurs d'onde sont utiles à la photosynthèse des plantes.

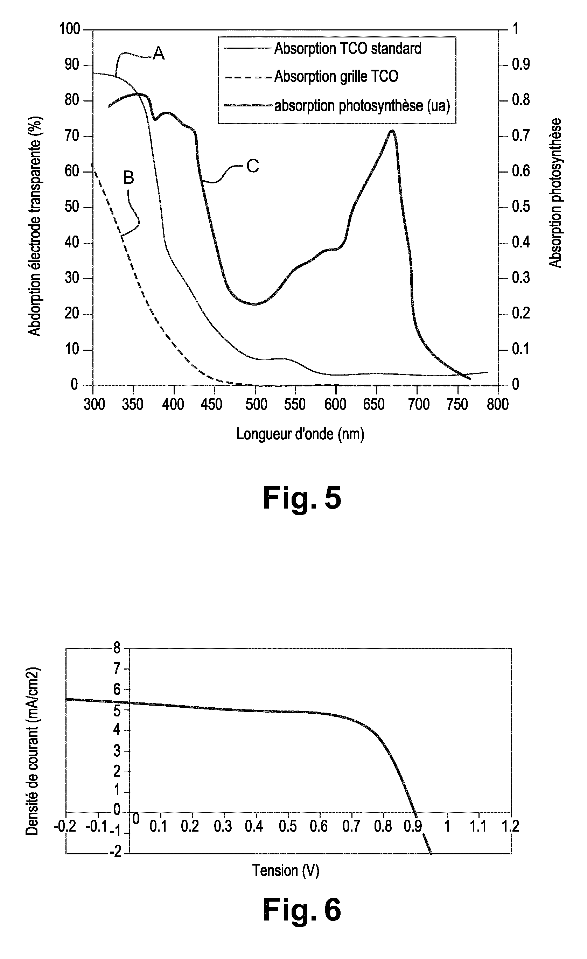

En effet, comme représenté sur la figure 5, le fait de réaliser une électrode sous forme de grille permet d'augmenter la transparence de l'électrode pour les longueurs d'onde inférieures à 520 nm. En effet, la courbe A représente l'absorption d'une électrode réalisée dans une couche pleine de ZnO :Al. La courbe B représente l'absorption d'une électrode réalisée dans le même matériau mais sous forme de grille présentant des ouvertures circulaires d'un diamètre sensiblement égal à 1µm. La courbe C représente les longueurs d'onde utilisées pour la photosynthèse des plantes. Comme on peut le voir sur la figure 5, le fait de réaliser l'électrode sous forme de grille permet d'augmenter de manière significative sa transparence pour les longueurs d'onde inférieures à 520 nm, qui sont également les longueurs d'onde majoritairement utilisées pour la photosynthèse des plantes, comme représenté par la courbe C.

En outre, le fait de réaliser les électrodes sous forme de grilles permet d'induire du piégeage optique au sein de la couche absorbante via la texturation des interfaces, ce qui permet d'augmenter le rendement quantique de la cellule photovoltaïque dans la gamme 520-620 nm et donc d'améliorer le rendement de cellule, y compris pour des faibles épaisseurs de couche absorbante.

Les dimensions transversales d des ouvertures de la grille et son épaisseur em sont de préférence choisies afin d'obtenir une électrode 2, 3 présentant :
- Une résistivité suffisante pour des applications agricoles, c'est-à-dire une résistivité inférieure à 10⁻³ ohm.cm,
- une transmission optique maximale pour les longueurs d'onde inférieures à 520 nm et supérieures à 620 nm et
- un facteur de diffusion de la lumière transmise maximal pour les longueurs d'onde comprises entre 520 et 620 nm.

Pour ce faire, la grille présente de préférence des dimensions latérales d comprises entre 0.5 µm et 10 µm, et de préférence entre 1 µm et 2.5 µm. En outre, l'électrode présente de préférence une épaisseur em comprise entre 250 nm et 2,5 µm et plus favorablement entre 500 nm et 1 µm.

Par ailleurs, les parois 8 de la grille présentent de préférence une largeur minimale I de 100 nm, afin de garantir la continuité électrique de l'électrode et la conduction des porteurs générés par la couche absorbante.

### Couche absorbante :

La couche absorbante 4 est choisie de façon à présenter une absorption maximale entre 520 et 620 nm, puisque ces longueurs d'onde sont peu utilisées pour la photosynthèse.

La couche absorbante présente de préférence un indice optique compris entre 3 et 4.

La couche absorbante 4 comporte de préférence un empilement de couches. Ainsi, selon un mode de réalisation, la couche absorbante 4 comporte :
- une première couche 9 en silicium amorphe dopée p. Pour cela, la couche en silicium amorphe peut être dopée avec du bore ;
- une deuxième couche 10 en silicium amorphe dopée n. Pour cela, la couche en silicium amorphe peut être dopée avec du phosphore.
- Une couche dite « intrinsèque » 11 en silicium amorphe hydrogéné, la couche intrinsèque 11 étant située entre la première couche 9 en silicium amorphe dopée p et la deuxième couche 10 en silicium amorphe dopée n.

La première couche 9 en silicium amorphe dopée p et la deuxième couche 10 en silicium amorphe dopée n permettent d'extraire les paires électrons-trous générés par l'absorption des photons du rayonnement solaire au sein de la couche intrinsèque 11. La première couche 9 en silicium amorphe dopée p peut être déposée du côté du substrat 1 comme représenté sur la figure 1, ou alors ce peut être la deuxième couche 10 en silicium amorphe dopée n qui est déposée du côté du substrat 1.

La couche intrinsèque 11 présente de préférence un gap compris entre 1,5 et 1,9 eV et plus favorablement entre 1,7 et 1,9 eV. Elle permet de convertir le rayonnement lumineux en paire électron-trou.

Selon un mode de réalisation, la couche intrinsèque 11 peut comporter du carbone afin de décaler l'absorption de la couche absorbante 4 vers les longueurs d'onde inférieures à 650nm.

Selon un autre mode de réalisation, la couche intrinsèque 11 peut comporter du germanium, ce qui permet de décaler l'absorption de la couche absorbante 4 vers les longueurs d'onde supérieures à 650nm.

La couche absorbante 4 présente de préférence une épaisseur optimisée en vue d'augmenter la transparence de la cellule solaire aux longueurs d'onde utiles à la photosynthèse, c'est-à-dire aux longueurs d'onde inférieures à 520 nm et supérieures à 620 nm. Pour ce faire, la couche absorbante 4 présente de préférence une épaisseur eₐ comprise entre 40 et 100 nm, et de manière plus préférentielle entre 50 et 70 nm.

### Procédé de fabrication d'une cellule photovoltaïque selon un mode de réalisation de l'invention :

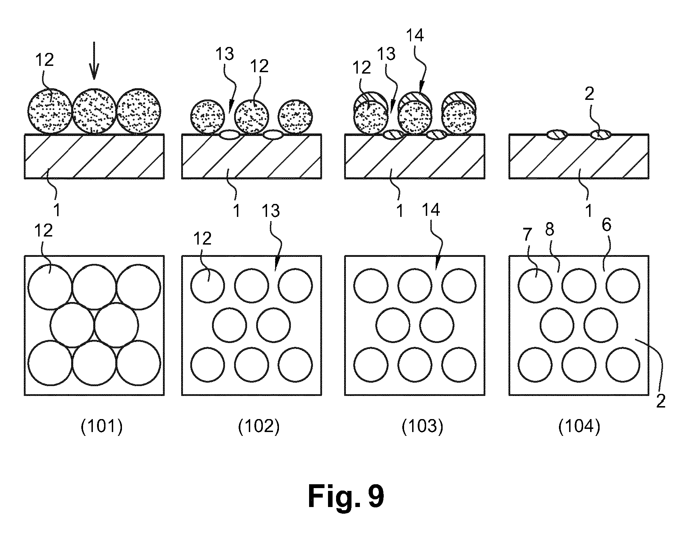

Un procédé de fabrication d'une cellule photovoltaïque selon un mode de réalisation de l'invention va maintenant être décrit en référence à la figure 9.

Le procédé comporte tout d'abord une étape de réalisation de la première électrode 2 sur le substrat 1.

Pour réaliser la première électrode, le procédé comporte tout d'abord une étape 101 de dépôt d'un tapis de microbilles 12 à la surface du substrat 1. Les microbilles 12 sont de préférence en silice. Leurs dimensions dépendent des dimensions voulues pour la grille 6.

Le procédé comporte ensuite une étape 102 de gravure partielle des microbilles 12 de façon à obtenir un interstice 13 de taille choisie entre deux microbilles 12 consécutives. Cette étape 102 de gravure est de préférence une étape de gravure plasma isotrope. La durée de gravure dépend des dimensions voulues pour les microbilles 12 et pour les interstices 13 à la fin de l'étape de gravure. Les dimensions des microbilles 12 et des interstices 13 dépendent des dimensions voulues pour la grille 6.

Le procédé comporte ensuite une étape 103 de dépôt de l'oxyde transparent conducteur 14 à la surface des microbilles 12. Cette étape de dépôt est de préférence effectuée par pulvérisation cathodique magnétron radio fréquence ce qui permet d'obtenir des propriétés opto-électriques compatibles avec l'application et appliqués à une température inférieure à 100°C.

Le procédé comporte ensuite une étape 104 de gravure des microbilles 12 de façon à ne conserver que l'électrode 2 sous forme de grille.

Le procédé comporte ensuite une étape de formation de la couche absorbante 4 à la surface de l'électrode 4. La ou les couches constituants la couche absorbante 4 est(sont) de préférence déposée(s) par dépôt chimique en phase vapeur assisté par plasma (ou PECVD, pour « Plasma-Enhanced Chemical Vapor Deposition » en anglais), car cette technique permet de moduler le gap de la couche absorbante de façon à ce qu'elle présente un gap compris entre 1,5 et 1,9 eV et de préférence compris entre 1,7 et 1,9 eV.

Le procédé comporte ensuite une étape de formation d'une deuxième électrode 3 à la surface de la couche absorbante 4. L'étape de formation de la deuxième électrode 3 est de préférence identique à l'étape de formation de la première électrode 2.

### Résultats expérimentaux :

Une cellule photovoltaïque selon un mode de réalisation de l'invention a été réalisée. Cette cellule photovoltaïque comporte :
- Un substrat 1 en verre ;
- Une première électrode 2 en oxyde de zinc dopé à l'aluminium. La première électrode 2 présente une géométrie de grille avec des ouvertures circulaires de 1µm de diamètre. La première électrode 2 présente une épaisseur égale à 500nm... ;
- Une couche absorbante 4 comportant une couche en silicium amorphe hydrogéné La couche absorbante 4 présente une épaisseur de 70nm;
- Une deuxième électrode 3 en oxyde d'indium dopé à l'oxyde d'étain et à l'oxyde de zinc.. La deuxième électrode 3 présente une épaisseur de 110nm...

La figure 6 représente l'évolution de la densité de courant en fonction de la tension dans cette cellule photovoltaïque.

Cette cellule photovoltaïque présente une tension de circuit ouvert V_{oc}=895mV, une densité de courant de J_{sc}=5.2 mA/cm², et un facteur de forme FF=66.7% et un rendement de 3,11 %. Ces mesures ont été réalisées à l'aide d'un banc de mesure I(V) équipé d'un simulateur solaire.

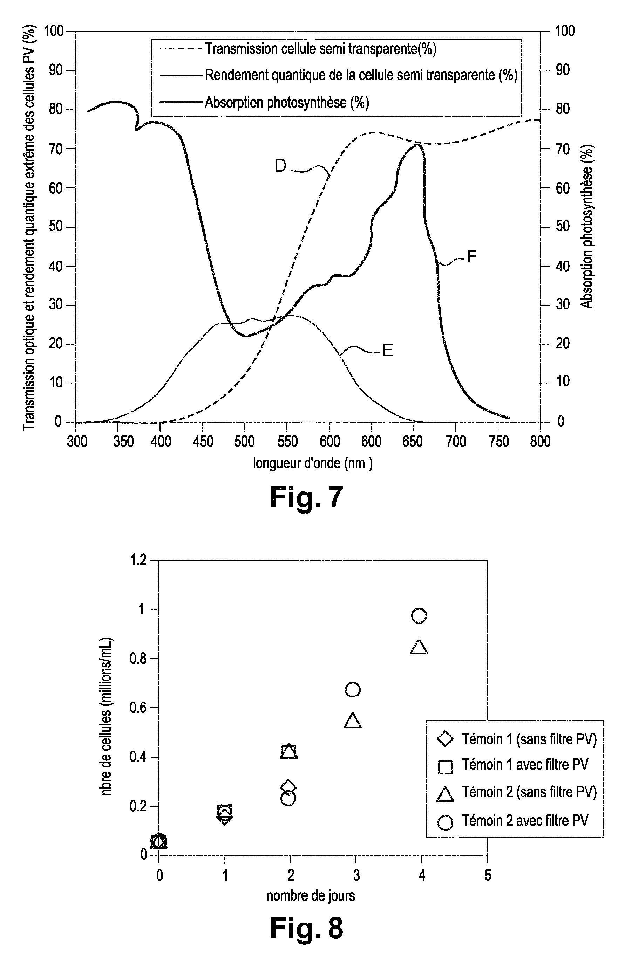

La figure 7 représente :
- le taux de transmission optique de cette cellule photovoltaïque en fonction de la longueur d'onde (courbe D) ;
- le rendement quantique de cette cellule photovoltaïque en fonction de la longueur d'onde (courbe E) ;
- l'absorption liée à la photosynthèse en général en fonction de la longueur d'onde (courbe F).

Cette cellule photovoltaïque permet d'obtenir des rendements de conversion photovoltaïque de 2% avec une transparence supérieure à 40 % dans les longueurs d'onde utiles à la photosynthèse. La cellule photovoltaïque permet de délivrer une puissance comprise entre 30 et 40Wc/m².

### Application dans le milieu agricole :

Une application potentielle de cette cellule solaire est l'alimentation électrique de photo-bioréacteurs pour la production de micro-algues.

Dans ce cadre, la cellule solaire décrite précédemment a été disposée entre une source lumineuse et un photo-bioréacteur contenant des micro-algues Phaeodactylum tricoenutum afin d'évaluer l'impact de la filtration d'une partie du spectre lumineux par la cellule solaire sur la croissance de micro-algues.

Pour cela, on a mesuré le nombre de micro-algues qui ont poussé dans :
- deux photo-bioréacteurs pour lesquels on a disposé une cellule photovoltaïque telle que décrite précédemment entre la source lumineuse et le photo-bioréacteur (témoin 1 et 2 avec filtre PV) ;
- deux photo-bio réacteurs pour lesquels aucune cellule photovoltaïque n'est interposée entre la source lumineuse et le photo-bioréacteur (témoin 1 et 2 sans filtre PV).

Le nombre de micro-algues qui ont poussées dans chacun des photo-bioréacteurs est représenté sur la figure 8. Comme on peut le voir sur cette figure, la présence de cellules photovoltaïques selon l'invention entre la source lumineuse et le photo-bioréacteur n'affecte pas la croissance des micro-algues.

Naturellement, l'invention n'est pas limitée aux modes de réalisations décrits en référence aux figures et des variantes pourraient être envisagées sans sortir du cadre de l'invention.

## Revendications

1. Cellule photovoltaïque pour serre agricole, la cellule photovoltaïque comportant :
- un substrat (1) transparent ;
- une première et une deuxième électrode (2, 3) en oxyde transparent conducteur;
- une couche absorbante (4) en silicium amorphe, la couche absorbante (3) étant disposée entre la première et la deuxième électrode (2, 3);
**caractérisée en ce qu'**au moins une des électrodes (2, 3) présente une forme de grille (6) percée par des ouvertures (7), chaque ouverture (7) présentant des dimensions transversales (d) comprises entre 0.5 µm et 10 µm, et de préférence entre 1µm et 2.5 µm, la grille (6) présentant une épaisseur (em) comprise entre 250 nm et 2,5 µm.

2. Cellule photovoltaïque selon la revendication précédente, dans laquelle la grille (6) comporte des parois (8), chaque paroi (8) séparant deux ouvertures (7) consécutives, chaque paroi (8) présentant une largeur (l) supérieure à 100 nm.

3. Cellule photovoltaïque selon l'une des revendications précédentes, dans laquelle la grille (6) est réalisée dans un des matériaux suivants : oxyde de zinc dopé à l'aluminium, oxyde d'indium dopé à l'oxyde d'étain, oxyde d'indium dopé à l'oxyde d'étain et à l'oxyde de zinc.

4. Cellule photovoltaïque selon l'une des revendications précédentes, dans laquelle la couche absorbante (4) présente une épaisseur (ea) comprise entre 40 et 100 nm, et de préférence entre 50 et 70 nm.

5. Cellule photovoltaïque selon l'une des revendications précédentes, dans laquelle la couche absorbante (4) comporte une couche de silicium amorphe hydrogéné.

6. Cellule photovoltaïque selon l'une des revendications 1 à 5, dans laquelle la couche absorbante (4) comporte du carbone.

7. Cellule photovoltaïque selon l'une des revendications 1 à 5, dans laquelle la couche absorbante (4) comporte du germanium.

8. Serre agricole comportant une paroi transparente, la paroi transparente étant recouverte au moins en partie d'une cellule photovoltaïque selon l'une des revendications précédentes.
